# EUROPÄISCHE PATENTANMELDUNG

(11) **EP 0 772 228 A2**
(43) Veröffentlichungstag der Anmeldung: **07.05.1997**
(21) Anmeldenummer: 96107218.8
(22) Anmeldetag: 07.05.1996
(51) Int. Cl.: H01L 21/00

(54) **Transportbehälter für scheibenförmige Objekte**

(30) Priorität: 03.11.1995 DE 19540963
(71) Anmelder: JENOPTIK Aktiengesellschaft, D-07743 Jena (DE)
(72) Erfinder: Schneider, Heinz, 07747 Jena (DE); Fabian, Peter, 07745 Jena (DE)
(74) Vertreter: Geyer, Werner

(57) **Zusammenfassung**

Bei einem Transportbehälter für scheibenförmige Objekte besteht die Aufgabe, ohne die Handhabbarkeit einzuschränken, Partikel beim Öffnen des Transportbehälters von dessen Innenraum fernzuhalten und zu entfernen, insbesondere auch solche, die sich in den Türspalten befinden. Die Reinigung soll als Selbstreinigungsprozeß auch dann wirksam sein, wenn mehrere Transportbehälter übereinandergestapelt sind und ein Zugriff wahlweise erfolgt.

Gemäß der Erfindung sind zumindest Teile des Rückwandbereiches einer verschließbaren Behälterhülle als Plenumkammer ausgebildet, die im Grundbereich und Deckbereich des Behälters einen verschließbaren Lufteintritt und einen verschließbaren Luftaustritt aufweist und von der über ein Filter eine Verbindung in das Behälterinnere besteht. Der Lufteintritt ist sowohl zu einem Anschluß eines Gasreservoirs als auch zu einem Luftaustritt eines weiteren Transportbehälters für eine Kopplung komplementär ausgebildet.

Die Erfindung ist bei der Herstellung integrierter Schaltkreise anwendbar.

## Beschreibung

Die Erfindung betrifft einen Transportbehälter für scheibenförmige Objekte, bei dem sich eine Behälterhülle in zwei sich gegenüberliegende Seitenbereiche mit fächerbildenden Vorsprüngen zur Objektaufnahme, einen Grund- und einen Deckbereich und einen Rückwandbereich gliedert, wobei eine dem Rückwandbereich gegenüberliegende Öffnung zur Entnahme und Beschickung mit einer Behältertür verschließbar ist und die Entnahme und Beschickung in einer Ebene parallel zur Oberfläche der Objekte erfolgt.

Für den Transport im Produktionprozeß und zur Beschickung von Halbleiterbearbeitungsanlagen ist es bekannt, sogenannte SMIF-Boxen, die ein relativ kleines abgeschlossenes Volumen besitzen, als Magazinbehälter zu verwenden. Üblicherweise ist die Box auf einen Öffnungsmechanismus in einer Einhausung aufsetzbar, die eine oder mehrere Arbeitsstationen staubgeschützt umschließt. Box und Öffnungsmechanismus besitzen einander angepaßte Verschlußelemente, die übereinanderliegend sich gleichzeitig öffnen lassen, so daß außen auf den Verschlußelementen aufliegende Staubpartikel dazwischenliegend eingeschlossen werden, wenn das Halbleiterscheibenmagazin zusammen mit den beiden Verschlußelementen in die Einhausung hinein abgesenkt wird. Die Box selbst umschließt die entstehende Öffnung in der Einhausung.
Infolge zyklischer Entnahme- und Beschickungsbewegungen, verbunden mit dem Öffnen und Schließen der Boxen, steigt die durch Reibung erzeugte Partikelkonzentration auf den Oberflächen der Halbleiterscheiben und in der umgebenden Luft.

Zur Vermeidung von Störungen der Gasatmosphäre in der Einhausung beim Öffnen der SMIF-Box wird in der US 5 169 272 ein Verfahren und eine Vorrichtung beschrieben, die zum Reinigen der SMIF-Box ein schrittweises Absenken des entriegelbaren Bodens, verbunden mit der Erzeugung von Druckunterschieden vorsehen. Der erzeugte Druckunterschied verhindert einen Gaseintritt in den Reinstraum beim Absenkvorgang und während der Reinigung der SMIF-Box mit Gas, das im Bereich des Bodens von einer Seite der SMIF-Box zur gegenüberliegenden geführt wird.

Zur Gewährleistung der Reinstraumbedingungen innerhalb der Box ist es nach der EP 313 693 A1 bekannt, einen Kanal vorzusehen, der den Innenraum der SMIF-Box direkt mit einem außerhalb liegenden Bereich verbindet. Über den Kanal kann in der SMIF-Box ein Vakuum oder ein Überdruck erzeugt sowie ein Gastransport in den Innenraum erfolgen. Wechselseitiges Unter-Druck-Setzen und Abpumpen über ein im Inneren der Box befindliches Filter soll der Partikelentfernung dienen.

Von Nachteil an beiden Lösungen ist die unvollkommene Durchströmung des Boxinnenraums.

Ein zeitlich effektiver Gasaustausch innerhalb einer SMIF-Box erfolgt mit einer technischen Lösung gemäß WO 93/05 002 A1, bei der von verschließbaren Kanälen, die in die Wandung der Box eingearbeitet sind, ein Gaszufuhrkanal in Mitteln zur Gasverteilung mündet. Ein Gasableitungskanal steht mit einem Gasauslaß in Verbindung, der dem Magazin entgegensetzt zu den Mitteln der Gasverteilung benachbart ist.

Die Technik der SMIF-Boxen ist besonders geeignet für Halbleiterscheiben mit herkömmlichem kleineren Durchmesser von 100 bis 200 mm. Aufgrund der Materialeigenschaften der Halbleiterscheiben werden diese SMIF-Boxen zusammen mit den verwendeten Magazinen mit zunehmendem Durchmesser der Halbleiterscheiben ungeeigneter als Transportbehälter.

Bekannterweise werden dann konstruktiv völlig anders aufgebaute Transportbehälter verwendet, die gleichzeitig die Magazinfunktion mit übernehmen. Eine Entnahme und Beschickung der Halbleiterscheiben, die in den Behälter in Fächer eingeschoben sind, erfolgt einzeln in einer Ebene parallel zur Oberfläche der Halbleiterscheiben, wobei der Transportbehälter mit einem senkrecht zur Ebene der Entnahme und Beschickung gerichteten Behälterdeckel verschließbar ist. Der Behälterdeckel wird somit im Gegensatz zur SMIF-Box nicht nach unten, sondern seitlich entfernt bzw. eingesetzt.
Für den effektiven Einsatz in der Halbleiterfertigung muß ein wahlweiser Zugriff in mehrere übereinander gestapelte Transportbehälter gestattet sein.

Verstärktes technisches Interesse kommt der Reinhaltung des Behälterinneren zu, weil aufgrund der mehr als doppelt so großen Fläche der Halbleiterscheiben sich zwangsläufig höhere Anforderungen an die Reinraumklasse ergeben und im vergrößerten Luftvolumen statistisch die Anzahl der absolut vorhandenen Partikel steigt. Außerdem wird im Moment des Öffnens der Tür dieser Behälter im Inneren ein Unterdruck erzeugt, der unkontrollierte Luftverwirbelungen entstehen läßt, so daß Partikel in den Behälter gelangen und sich ablagern können.

Bekannt gewordene batteriegetriebene Aktivboxen, die über ein internes Filtersystem ständig Reinstluft zur Verfügung stellen, besitzen den Nachteil, daß die erforderliche Luftströmung von ca. 0.5 m/s und die damit zusammenhängende Leistung von batteriegetriebenen Motoren bei größer werdenden Behältern nicht mehr aufgebracht werden kann, zumal die Behälter noch manuell handhabbar bleiben sollen.

Aufgabe der Erfindung ist es, ohne die Handhabbarkeit einzuschränken, Partikel beim Öffnen des Transportbehälters von dessen Innenraum fernzuhalten und zu entfernen, insbesondere auch solche, die sich in den Türspalten befinden. Die Reinigung soll als Selbstreinigungsprozeß auch dann wirksam sein, wenn mehrere Transportbehälter übereinandergestapelt sind und ein Zugriff wahlweise erfolgt.

Die Aufgabe wird durch einen Transportbehälter für scheibenförmige Objekte gelöst, bei dem sich eine Behälterhülle in zwei sich gegenüberliegende Seitenbereiche mit fächerbildenden Vorsprüngen zur Objektaufnahme, einen Grund- und einen Deckbereich und einen Rückwandbereich gliedert, wobei eine dem Rückwandbereich gegenüberliegende Öffnung zur Entnahme und Beschickung mit einer Behältertür verschließbar ist und die Entnahme und Beschickung in einer Ebene parallel zur Oberfläche der Objekte erfolgt. Zumindest Teile des Rückwandbereiches sind als Plenumkammer ausgebildet, die im Grundbereich und Deckbereich einen verschließbaren Lufteintritt und einen verschließbaren Luftaustritt aufweist und von der über ein Filter eine Verbindung in das Behälterinnere besteht. Der Lufteintritt ist sowohl zu einem Anschluß eines Gasreservoirs als auch zu einem Luftaustritt eines weiteren Transportbehälters für eine Kopplung komplementär ausgebildet.

Vorteilhafterweise sind in den Lufteintritt und den Luftaustritt zum Öffnen und Verschließen Ventile eingesetzt, bei denen ein Vorsprung an einem Ventil zum gegenseitigen Finden und Arretieren in eine Ausnehmung am anderen Ventil eintaucht.

Sowohl im Zustand der Lagerung, bei der die Behältertür die Behälterhülle verschließt, als auch bei einer Be- und Entladung einer Halbleiterbearbeitungsmaschine, bei der die Behälterhülle geöffnet ist, erfolgt eine Kopplung der Plenumkammer mit dem Gasreservoir.

Durch das Verbinden einer Plenumkammer mit einem Transportbehälter wird dessen reinraumgerechtes Öffnen, das Wechseln der scheibenförmigen Objekte und die Be- und Entladung von Halbleiterbearbeitungsmaschinen unter Reinstraumbedingungen gewährleistet.

Kurze Zeit nach dem Anschließen des Transportbehälters oder eines gestapelten Verbandes von Behältern an das Gasreservoir steht das Behälterinnere unter Überdruck. Die Zufuhr von Druckluft erfolgt bei einem einzelnen Transportbehälter über das Ventil zum Lufteintritt, bei einem Verband durch das nach außen freie Ventil zum Lufteintritt. Die anderen Ventile zum Lufteintritt sind durch den Stapelvorgang jeweils mit einem Ventil zum Luftaustritt verbunden.

Der im Behälterinneren vorherrschende Überdruck verhindert die Bildung eines Unterdruckes beim Öffnen des Transportbehälters. Gleichzeitig wird durch die kontinuierliche Versorgung mit Druckluft eine gleichmäßige Anströmung der scheibenförmigen Objekte mit Reinstluft erzeugt, sobald die Tür geöffnet wird. Bei geschlossener Tür befinden sich die Objekte in einer ruhenden Reinstluftatmosphäre.

Durch den mit der Erfindung verbundenen Selbstreinigungsprozeß entfallen sonst notwendige Reinigungszyklen.

Die Erfindung soll nachstehend anhand der schematischen Zeichnung näher erläutert werden. Es zeigen:
- Fig. 1: einen geöffneten Transportbehälter von oben
- Fig. 2: den Transportbehälter in Seitenansicht
- Fig. 3: eine Ansicht auf die Rückwand des Transportbehälters
- Fig. 4: ein Verband zweier gestapelter Transportbehälter
- Fig. 5: ineinandergreifende Ventile des Luftein- und -austrittes

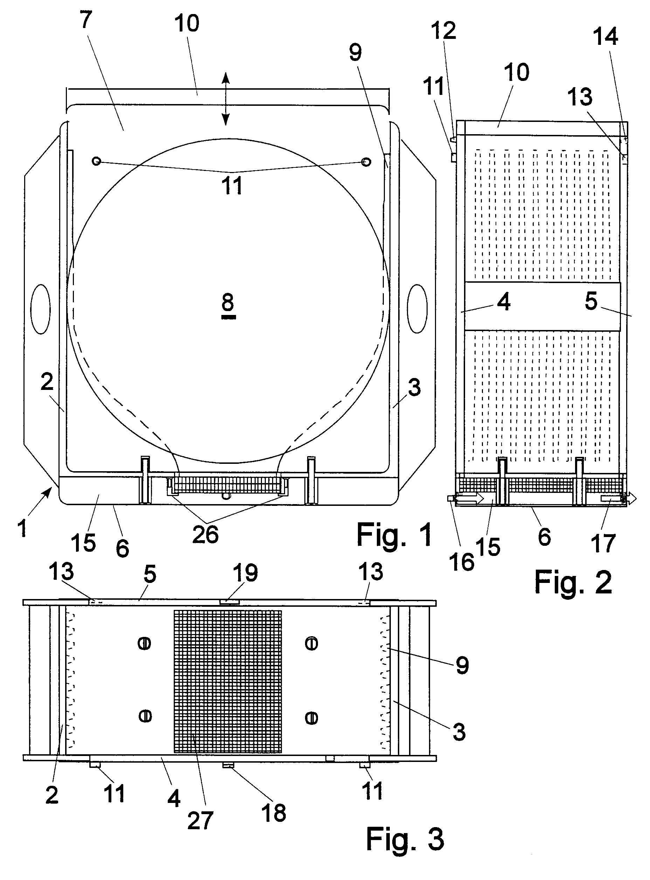

Gemäß den Figuren 1 bis 4 besteht der Transportbehälter aus einer Behälterhülle 1, die sich in gegenüberliegende Seitenwände 2, 3, einen Grundbereich 4, einen Deckbereich 5 und einen Rückwandbereich 6 gliedert. Dem Rückwandbereich 6 gegenüberliegend ist eine Entnahme- und Beschickungsöffnung 7 für scheibenförmige Objekte 8, wie z. B. Halbleiterscheiben oder Schablonen freigelassen, zu deren Aufnahme fächerbildende Vorsprünge 9 in den sich gegenüberliegenden Seitenwänden 2, 3 dienen. Die Entnahme und Beschickung der Objekte 8 erfolgt einzeln in einer Ebene parallel zur Oberfläche der Objekte 8. Eine Behältertür 10 dient zum Verschließen der Öffnung 7 und wird dazu vertieft in die Behälterhülle eingeschoben und anschließend geeignet arretiert.
Zum schnellen Finden der richtigen Lage beim Aufsetzen des Transportbehälters auf ein entsprechendes, nicht dargestelltes Aufnahmeelement einer Halbleiterbearbeitungsmaschine oder bei der Lagerung und beim Stapeln mehrerer Transportbehälter in der Höhe sind außen an der Behälterhülle Zentrierstifte 11 und eine Führungsschiene 12 und passend dazu entsprechende Vertiefungen 13, 14 zum Eingriff vorgesehen.
Der Rückwandbereich 6 ist als Plenumkammer 15 ausgebildet, die im Grundbereich 4 einen Lufteintritt 16 und im Deckbereich 5 einen Luftaustritt 17 besitzt. Der Lufteintritt 16 und der Luftaustritt 17 sind durch Druckventile 18, 19 verschließbar, von denen das Druckventil 18 in komplementärer Weise sowohl zu dem Druckventil 19 als auch zu einem Ventil in einem nicht dargestellten Gasreservoir ausgebildet ist.

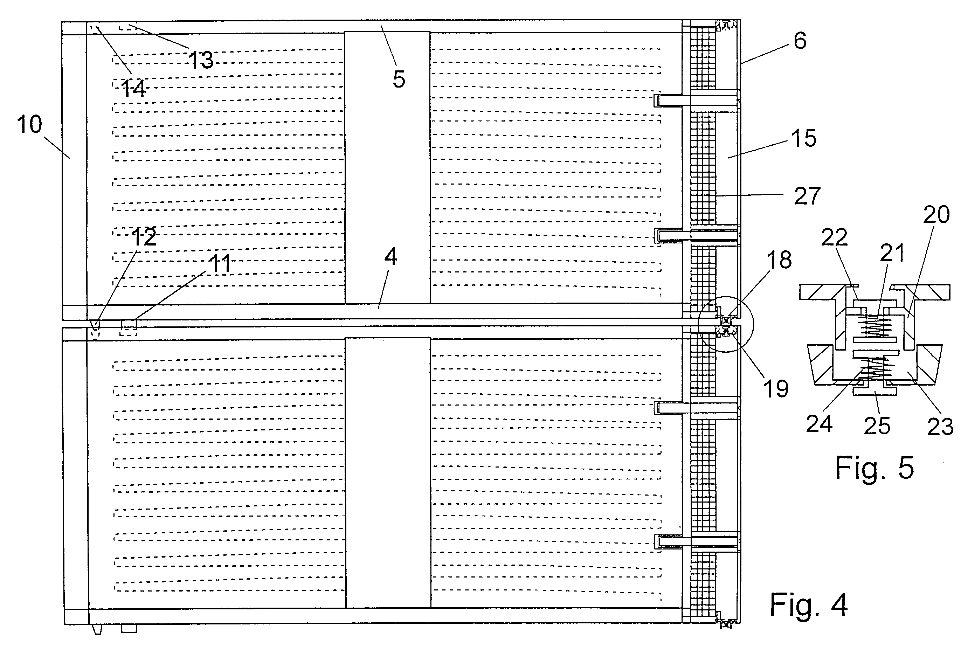

Fig. 5 verdeutlicht diese komplementäre Ausbildung, nach der beide Ventile 18, 19 sich ineinandergreifend gegenseitig öffnen. Ein zylindrischer Vorsprung 20 am Ventil 18, der einen gegen eine Feder 21 verschiebbaren Stößel 22 umschließt, taucht in eine als Ausnehmung ausgebildete Vertiefung 23 im Ventil 19 ein, die ebenfalls einen gegen eine Feder 24 verschiebbaren Stößel 25 umschließt. Mit dem gegenseitigen Umschließen der Ventilelemente ist sowohl im Verhältnis eines Transportbehälters zu dem Gasreservoir als auch der Transportbehälter zueinander gleichzeitig eine Funktion des Findens und Arretierens verbunden.
Ein in Filterstützen 26 gehaltenes Filter 27 innerhalb der Plenumkammer 15 verschließt eine dem Gasübertritt in das Behälterinnere dienende Öffnung.

Zum Zweck der Lagerung oder zur Be- und Entladung von Halbleiterbearbeitungsmaschinen wird ein einzelner Transportbehälter oder der untere eines Verbandes von übereinandergestapelten Transportbehältern auf ein Aufnahmeelement gestellt, von dem aus über ein Ventil, das dem Ventil 19 entspricht, eine Verbindung zu dem Gasreservoir besteht. Die in die Plenumkammer des einzelnen Transportbehälters oder in die Kammern der verbundenen Behälter eintretende Druckluft bildet jeweils ein entsprechendes Plenum aus und über das Filter 27 strömt ein gleichmäßiger, verwirbelungsarmer Gasstrom in das Behälterinnere. Bei verschlossenen Transportbehältern bildet sich ein entsprechender Innendruck aus, durch den beim Öffnen Partikel, insbesondere auch solche, die sich in den Türspalten befinden, vom Behälterinnenraum ferngehalten werden. Vorhandene Partikel werden mit dem in der Halbleiterbearbeitungsmaschine vorhandenen Gasstrom abgeführt. Im weiteren Verlauf der Be- und Entladung ist der geöffnete Transportbehälter von einem ständig strömenden laminaren Luftstrom durchsetzt.

## Patentansprüche

1. Transportbehälter für scheibenförmige Objekte; bei dem sich eine Behälterhülle in zwei sich gegenüberliegende Seitenbereiche mit fächerbildenden Vorsprüngen zur Objektaufnahme, einen Grund- und einen Deckbereich und einen Rückwandbereich gliedert, wobei eine dem Rückwandbereich gegenüberliegende Öffnung zur Entnahme und Beschickung mit einer Behältertür verschließbar ist und die Entnahme und Beschickung in einer Ebene parallel zur Oberfläche der Objekte erfolgt, dadurch gekennzeichnet, daß
zumindest Teile des Rückwandbereiches (6) als Plenumkammer (15) ausgebildet sind, die im Grundbereich (4) und Deckbereich (5) einen verschließbaren Lufteintritt (16) und einen verschließbaren Luftaustritt (17) aufweist und von der über ein Filter (27) eine Verbindung in das Behälterinnere besteht, und daß der Lufteintritt (16) sowohl zu einem Anschluß eines Gasreservoirs als auch zu einem Luftaustritt (17) eines weiteren Transportbehälters für eine Kopplung komplementär ausgebildet ist.

2. Transportbehälter nach Anspruch 1, dadurch gekennzeichnet, daß
in den Lufteintritt (16) und den Luftaustritt (17) zum Öffnen und Verschließen Ventile (18, 19) eingesetzt sind, bei denen ein Vorsprung (20) an einem Ventil (18) zum gegenseitigen Finden und Arretieren in eine Ausnehmung (23) am anderen Ventil (19) eintaucht.

3. Transportbehälter nach Anspruch 2, dadurch gekennzeichnet, daß
sowohl im Zustand der Lagerung, bei der die Behältertür (10) die Behälterhülle (1) verschließt, als auch bei einer Be- und Entladung einer Halbleiterbearbeitungsmaschine, bei der die Behälterhülle (1) geöffnet ist, eine Kopplung der Plenumkammer (15) mit dem Gasreservoir erfolgt.
